# EUROPEAN PATENT SPECIFICATION

(11) **EP 1 448 997 B1**
(45) Date of publication and mention of the grant of the patent: **08.03.2006**
(21) Application number: 02755621.6
(22) Date of filing: 19.07.2002
(51) Int. Cl.: G01R 11/00, G01R 11/38, G01R 11/40, G01R 22/00, G01R 11/32

(54) **ENERGY CONSUMPTION CONTROL UNIT**
STEUEREINHEIT FÜR DEN ENERGIEVERBRAUCH
UNITE DE COMMANDE DE CONSOMMATION D'ENERGIE

(30) Priority: 20.07.2001 IN MA05932001
(43) Date of publication of application: 25.08.2004
(73) Proprietor: Manchanahally Venkataramasastry, Satyanarayana, Karnataka State, 560 079 Bangalore (IN)
(72) Inventor: Manchanahally Venkataramasastry, Satyanarayana, Karnataka State, 560 079 Bangalore (IN)
(74) Representative: Korkut, Nazli Tugba
(86) International application number: PCT/IN2002/000152
(87) International publication number: WO 2003/008983

(56) References cited:
- EP-A- 0 295 864
- EP-A- 0 319 235
- EP-A- 0 420 545
- WO-A-96/39633
- WO-A-99/38073
- FR-A1- 2 793 090
- SG-A1- 73 561
- US-A- 5 590 179
- STAUFFER ET AL: "Smart enabling system for home automatisation" May 1991 (1991-05), IEEE TRANSACTIONS ON CONSUMER ELECTRONICS , USA , XP002003950 * the whole document *

## Description

This invention relates to an energy consumption control Unit which is intended to limit the Consumption of Electrical energy to a predetermined value. Whenever the electric supply is present and the consumption of the connected load is within the specified limit, the load gets the supply. Whenever the consumption exceeds the specified value beyond a pre-set time, the power supply to the load gets disconnected automatically or a signal is initiated to take corrective action. The reconnection can be automatic, programmable or manual, as desired.

### PRIOR ART:

US Patent No. 5590179 describes a remote automatic meter reading apparatus which is capable of sensing, calculating and storing power consumption values at a plurality of electrical utility customer sites and communicating such power consumption values via a communication interface to a central utility site.

EP patent NO. 0420545 describes an electronic watthour meter that is digitally configurable to operate as several different types of watthour meters for metering electrical energy from a variety of different electric utility services and automatic scaling of line input currents is provided to scale the voltage input to an analog to digital converter over selected ranges such that low level and high level input signals are measured in an optimum range.

EP Patent No. 0319235 describes an automated system for controlling the distribution of different services within a house and the said system includes an appliance coordination data network for communicating relatively low spped digital data within the house, a high capacity data network for transferring high speed digital data within the house, etc.

Reference is also made to IEEE Transactions on Consumer Electronics' paper entitled "Smart Enabling System for Home Automation" that provides the common resources needed for home automation in a multi-product, multi-vendor environment.

French patent No. 2793090 describes a prepayment energy control mechanism which has a processing assembly commanding the opening of a relay when a set energy consumption level is met. The relay is monostable and has a central unit producing binary signals at a predetermined frequency and a frequency conversion interface connecting to the relay.

Electricity is normally supplied by distributing Agencies or a Captive Power Source. For Technical and Commercial reasons, it is often necessary to limit the consumption to any particular load or to a particular consumer. The conventional method that is adopted is to measure the energy (metering) consumed by a load or measure the maximum demand which is the peak load consumed by any consumer. These measurements will provide information regarding consumption of energy by a consumer or load and help in arriving at the cost of consumption. The instruments do not limit the supply of energy to any consumer or load. Hence, the consumer or load can continue to draw power without any limit. The energy meters are normally located with in the consumer premises and the instances of meter tampering and by-passing are not uncommon which will further aggravate the problem of system overloading and revenue loss to the supply companies.

### Description of the Invention:

The device of the present invention is more fully described hereunder:

The energy consumption control unit is a measuring and control/cut off device which checks the consumption to the connected load.

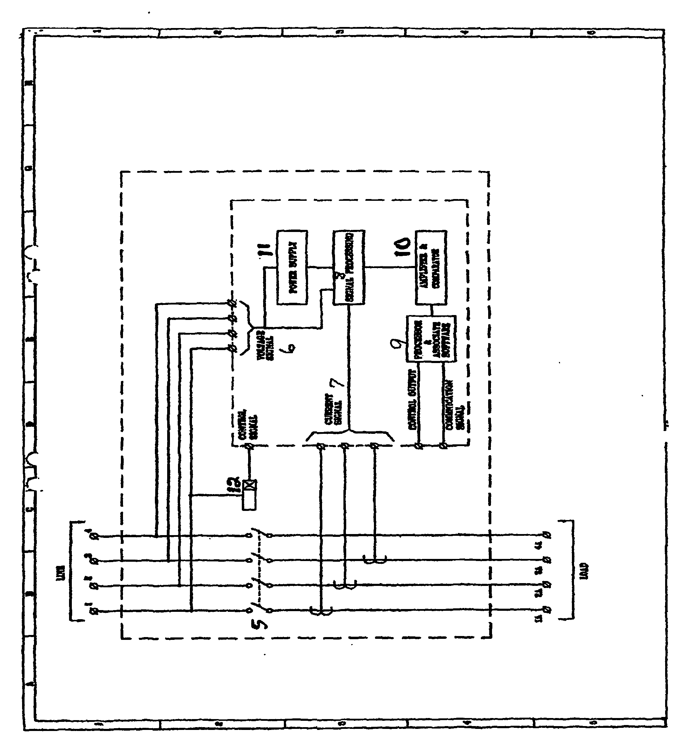

This invention will now be described with reference to the accompanying drawing. The supply of Electricity to a consumer or to a load is connected through the input terminal (1, 2, 3, 4) and through the contacts of an electrically operated disconnecting terminals 5 to terminals (1A, 2A, 3A & 4A) to which load terminals will be connected. There will be two each input and output terminals for a single phase system, three each input and output terminals for 3 phase three wire system and four each input and output terminals for 3 phase four wire system. The disconnecting terminals (5) will receive the instruction through the cut off mechanism (12) provided in the control unit.

A voltage signal (6) from the input terminals and a current signal (7) from each of the phases is taken to the signal processing unit (8) for sensing. These signals are proportional to the consumption by the load.

A processor (9) with an embedded software measures the current or power consumption continuously. The processor (9) will be loaded with a set of software instructions such as allowable consumption, allowable excess consumption, allowable time for excess consumption, the nature of output signals to be provided in case of excess consumption, the manner and duration of disconnection of the load on extended excess power drawings from supply sources, the means of re-connection of the load, interruption data storage and data communication. An amplifier and comparator (10) is provided in between the signal processing unit (8) and the processor (9) to amplify the signals received from the processing unit 8. the entire unit is provided with a power supply unit (11). it may be noted that the amplifier and comparator unit can be an individual unit or it can be included in the processor itself.

The actual dynamic values of the consumption parameters are continuously compared to the stored instructions in the processor. Whenever a deviation is seen by way of excess consumption, the processor executes a programmed instruction.

This instruction could be for the execution of one or more of the following tasks:
(i) Full or Partial load disconnection;
(ii) Disconnection for a pre-determined duration;
(iii) Provide a warning signal of excess load;
(iv) Record data of excess load and duration with date and time stamping; and
(v) Provide a communication of excess load data through an appropriate link to a host computer for data logging of individual units and analysis where more than one consumption control units are connected in a supply network. Being a software based system, each device can have its own identity by a specific address code that helps remote monitoring and remote data exchange between a host computer and any specific device through any protocol, including unloading the data through a hand held device, or radio frequency signals.

The device can be used either as an individual piece of equipment or integrated in to a system.

As an individual unit it can be mounted on a pole top or with in a feeder pillar box in an overhead or under ground distribution system, providing supply to individual consumers. It can also be mounted with in the consumer premises or on a specific load. The unit can be put in to any suitable enclosure to make it scalable, tamper proof and weather proof.

On board flashing lamp in the event of supply cut off due to excess load can provide a visual alert.

When integrated with an energy measuring instrument or meter, it can check the energy consumption beyond a pre-determined peak load and initiate a cut off or warning signal. Similarly, when integrated and housed inside a distribution transformer in association with an electrically operated cut off device, it can continuously monitor the load on the distribution transformer and initiate partial or total disconnection of load to protect the transformer from burn-outs due to overload. On the same lines, the device can be integrated with any electrically operated load disconnecting devices such as contactors and breakers and turn them into self regulating switching equipments.

## Claims

1. An energy consumption control unit comprising one or more-input terminals (1 to 4), signal receiver, inbuilt power supply unit (11), signal processor (8), comparators and amplifier (10), communication device, a switching device (5) and output terminals and communication outputs, a processor (9) with an embedded software to monitor:
i) Allowable consumption;
ii) Allowable excess consumption;
iii) Allowable time for excess consumption;
iv) The nature of output signals to be provided in case of excess consumption;
v) The manner and duration of disconnection of the load on extended excess power drawings from supply sources;
vi) The means of reconnection of the load; and
vii) Interruption data storage and data communication,
the said software compares one or more of the actual dynamic values of the consumption parameters continuously to the stored instructions and executes a set of instruction if a deviation is seen by way of excess consumption **characterized in that** means (12) are provided to either warn or cut off supply to the load when the present load limits are exceeded, said control unit can either housed in its own enclosure or as a sub-system and which can be conveniently mounted on distribution pole, feeder box or directly on a load or at any point between the source of supply and ultimate load, a specific address code being allotted to each unit to enable remote monitoring and remote communication between a host computer and any specific device through appropriate communication protocols.

2. An energy consumption control unit as claimed in claim 1, wherein said instructions are for the execution of one or more of the following tasks:
i) Full or partial load disconnection;
ii) Disconnection for a pre-determined period of time;
iii) Provide a warning signal of excess load;
iv) Record data of excess load and duration with date and time stamping; and
v) Provide a communication of excess load data through an appropriate link to a host computer for data logging of individual units where more than one consumption control units are connected in a supply network.

3. . An energy consumption control unit as claimed in claims 1 and 2, wherein said unit can also connected to or integrated with instruments and devices including energy meter, distribution transformer, and manually or electrically operated load disconnecting devices to make then automatically load responsive.

## Patentansprüche

1. Eine Steuereinheit für den Energieverbrauch, enthaltend eine oder mehrere Eingabestationen (1 bis 4), Signalempfänger, einmontierte Energieversorgungseinheit (11), Signalverarbeiter (8), Komparatoren und Amplifikatoren (10), Kommunikationsvorrichtung, eine Schaltvorrichtung (5) und Ausgabestationen und Kommunikationsausgaben, einen Verarbeiter (9) mit einer eingebauten Software zur Überwachung:
i) des zulässigen Verbrauchs;
ii) des zulässigen Verbrauchs im Übermass;
iii) der zulässigen Zeit für den Verbrauch im Übermass;
iv) der Beschaffenheit der Ausgabesignale gesandt im Falle des Verbrauchs im Übermass;
v) der Art und Dauer der Abschaltung der Ladung auf den verlängerten Energieabzügen im Übermass von den Versorgungsquellen;
vi) der Wiederverbindungsmittel der Ladung; und
vii) der Unterbrechung der Datenspeicherung und der Datenkommunikation,
wobei die genannte Software eine oder mehrere aktuelle dynamische Werte der Verbrauchparameter ständig mit den gespeicherten Anweisungen vergleicht und einen Anweisungssatz ausführt, wenn eine Abweichung durch den Verbrauch im Übermass beobachtet wird, **dadurch gekennzeichnet, dass** Mittel entweder zur Warnung oder zum Verhindern der Versorgung zu der Ladung zur Verfügung gestellt werden, wenn die betreffenden Ladungsgrenzen überschritten sind, die genannte Steuereinheit entweder in ihrem eigenen Gehäuse oder als Subsystem angeordnet werden kann, welches in geigneter Weise auf den Verteilungspol, die Zuführungsbox oder unmittelbar auf eine Ladung oder an irgendeinen Punkt zwischen der Versorgungsquelle und der letzten Ladung montiert werden kann, ein spezifischer Adressencode jeder Einheit zugeordnet wird, um die Fernüberwachung und die Fernkommunikation zwischen einem Hostrechner und irgendeiner spezifischen Vorrichtung durch geeignetes Kommunikationsprotokoll zu ermöglichen.

2. Eine Steuereinheit für den Energieverbrauch nach Anspruch 1, wobei the genannten Anweisungen für die Erledigung einer oder mehrerer folgender Aufgaben bestimmt sind:
i) Abschaltung der Ladung im Ganzen oder teilweise;
ii) Abschaltung für eine vorbestimmte Zeitperiode;
iii) Sendung eines Warnsignals im Falle einer Ladung im Übermass;
iv) Aufnahme der Daten für die Ladung im Übermass und die Dauer mit der Prägung des Datums und der Zeit; und
v) Erstellen der Kommunikation für die Ladung im Übermass durch einen geigneten Link zu einem Hostrechner für die Datenerfassung der individuellen Einheiten, wo mehrere Steuereinheiten für den Verbrauch in einem Stromversorgungsnetz verbunden werden.

3. Eine Steuereinheit für den Energieverbrauch nach Anspruch 1 and 2, wobei the genannten Einheiten mit den Geräten und Vorrichtungen verbunden oder integriert werden einschliesslich der Energiemeter, Verbreitungstransformatoren, und handbetätigten oder elektrisch betriebenen Vorrichtungen für Ladungsabschaltung zur späteren automatischen Förderung der Ladung zur Reaktion.

## Revendications

1. Une unité de commande de consommation d'énergie comprenant un ou plusieurs terminaux d'entrée (de 1 à 4), récepteur de signal, bloc d'alimentation incorporé (11), processeur de signal (8), comparateurs et amplificateur (10), dispositif de communication, un dispositif de commutation (5) et des terminaux de sorties et des sorties de communication, un processeur (9) avec un logiciel incorporé, pour surveiller:
i) la consommation admissible;
ii) la surconsommation admissible;
iii) le temps admissible de surconsommation;
iv) la nature des signaux de sorties à fournir dans le cas de surconsommation;
v) la manière et la durée de découplage de la charge pendant les périodes prolongées de surabsorption de courant des sources d'alimentation;
vi) les moyens de recouplage de la charge; et
vii) la mise en mémoire des données de coupure et la communication de données;
ledit logiciel compare continuellement l'une ou plusieurs des valeurs dynamiques réelles des paramètres de consommation avec les instructions mises en mémoire et exécute un ensemble d'instructions si une déviation est constatée à cause d'une surconsommation; **caractérisée en ce que** des moyens (12) sont fournis soit pour avertir, soit pour couper l'alimentation vers la charge quand les limites présentes de charge sont dépassées; ladite unité de commande peut, soit être placée dans son propre coffret, soit être arrangée comme un sous-système et peut convenablement être montée sur le pôle de distribution, la boîte d'alimentation ou directement sur une charge ou à tout point entre la source d'alimentation et la charge finale, un code spécifique d'adresse étant attribué à chaque unité pour permettre la surveillance à distance et la communication à distance entre un ordinateur hôte et tout dispositif spécifique, par l'intermédiaire des protocoles de communication appropriés.

2. Une unité de commande de consommation d'énergie selon la revendication 1, dans laquelle lesdites instructions sont destinées à l'exécution d'une ou de plusieurs des tâches suivantes:
i) découplage complet ou partiel de charge;
ii) découplage pour une période de temps prédéterminée;
iii) assurer un signal d'avertissement de surcharge;
iv) enregistrer, avec le marquage de la date et du temps, les données de surcharge et de durée; et
v) assurer une communication de données de surcharge par l'intermédiaire d'une liaison appropriée vers un ordinateur hôte destiné à la consignation de données des unités individuelles, où plus d'une unité de commande de consommation sont connectées dans un réseau d'alimentation.

3. Une unité de commande de consommation d'énergie selon les revendications 1 et 2, dans laquelle ladite unité peut aussi être connectée aux, ou intégrée avec des instruments et dispositifs comprenant compteur d'énergie, transformateur de distribution et des dispositifs de découplage de charge actionnés manuellement ou électriquement, pour les rendre alors sensible à la charge automatiquement.
